(19) Europäisches Patentamt

European Patent Office

Office européen des brevets

(11) **EP 3 686 583 A1**

(12) # EUROPEAN PATENT APPLICATION

(43) Date of publication:
**29.07.2020 Bulletin 2020/31**

(21) Application number: **20020034.3**

(22) Date of filing: **23.01.2020**

(51) Int Cl.:
**G01N 27/02** (2006.01)    **G01R 1/00** (2006.01)
**G01R 27/00** (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.01.2019  PCT/IB2019/050574**

(71) Applicant: **TGTW Group B.V.**
**2909 LA Capelle aan den Ijssel (NL)**

(72) Inventor: **Kleczewski, Lazlo**
**1511 WV Oostzaan (NL)**

(74) Representative: **Kosti, Vasiliki**
**Kladeou 8**
**26442 Patra (GR)**

(54) # TEMPERATURE DEPENDENT ELECTRICAL IMPEDANCE SPECTROSCOPY FOR IDENTIFYING AN UNKNOWN MATERIAL

(57)    A method for identifying an unknown material comprising the steps of first measuring the temperature-related impedance change of a set of known substances in a first capacitor, whilst sweeping the temperature of the sample in a predetermined range; storing the results in a database; measuring the impedance change to a temperature sweep of an unknown substance in the same range of temperatures; comparing the measured change to the stored values and determining the best match between the unknown substance and the stored values.

FIG. 1

EP 3 686 583 A1

## Description

BACKGROUND

The invention relates to electrical impedance spectroscopy to identify material samples. Electrical impedance spectroscopy is a non-contact method typically using a capacitor to determine properties of materials. A test material is positioned in the gap between the capacitor's plates. The capacitor is excited with an ac voltage that produces an electric field in the test material. The electrical field, in turn, induces an electromotive force on charged particles in the test material, which causes a charge imbalance and a resultant electric field in the test material. The imbalance results in a measurable change in the capacitor's impedance $Z$, where $Z = 1/j\omega C$, $\omega$ = the radian frequency of the ac voltage, $C$ = the capacitance of the capacitor, and $j = \sqrt{-1}$.

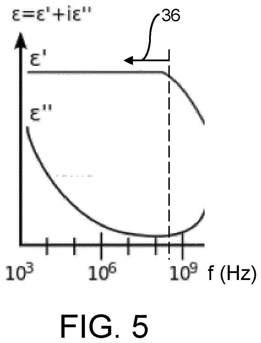

For a parallel-plate capacitor, $C = \varepsilon A/d$, where $\varepsilon$ is the permittivity of the material between the capacitor's plates, $A$ is the area of the plates flanking the material, and $d$ is the distance between the parallel plates; i.e., the plate separation. As shown in FIG. 5 for a generic material, the permittivity is complex and varies with frequency. The complex permittivity ($\varepsilon = \varepsilon' + j\varepsilon''$) includes a real component $\varepsilon'$ and an imaginary component $\varepsilon''$. If $A$ and $d$ are fixed constants, the capacitance $C$ is proportional to the complex permittivity $\varepsilon$. As the complex electrical impedance $Z$ is inversely proportional to the capacitance $C$, $Z$ is also inversely proportional to $\varepsilon$.

So different materials produce different electrical impedances in the capacitor. According to known methods, the different impedances caused by different materials are used to identify the materials.

SUMMARY

A material identification system embodying features of the invention comprises a first and second capacitors, each having a first plate and a second plate. At least one first signal generator excites the first and second capacitors with a sequence of ac signals that produce electric fields in the first and second capacitors from the first plates to the second plates. Each of the ac signals is at a different frequency over a frequency range. A reference material is disposed in the electric field of the first capacitor, and a sample material is disposed in the electric field of the second capacitor. A voltage-comparison system compares the voltage across the first capacitor to the voltage across the second capacitor to determine whether the sample material matches the reference material.

Besides frequency, temperature has a well-known effect on the impedance of substances, whereby the impedance of a substance changes in relation with the temperature of the substance. In order to counter these effects, the manufacturers of capacitors whereby any change in impedance of the dielectric causes the effective capacitance of the capacitors to change, go to great length to compensate or eliminate these, for them negative effects. This can for example be done by either one or a combination of methods like stabilizing the temperature with e.g. Peltier cooling modules or appropriate mechanical design.

However, as these temperature-related impedance changes have a predictable behavior in relation to both temperature and frequency, this effect can also be used to measure the composition of the substance.

This can be obtained by adding to the above presented method a temperature-related shift of impedance as follows: first measuring the temperature-related impedance change of known substances whilst sweeping the temperature of the sample in a predetermined range, storing the results in a database, measuring the impedance change to a temperature sweep of an unknown substance in the same range of temperatures, comparing the measured change to the stored values and determining the best match between the unknown substance and the stored values.

Consequently, the present method embodying features of the invention for identifying a sample material comprises the following steps:

At the calibration phase we measure the temperature-related impedance change of a set of known substances whilst sweeping the temperature of the sample in a predetermined range. The temperature sweep at this stage is preferably linear, in order to get a very large amount of data. This is the calibration phase and characterization of several materials.

We are then storing the results in a database or library of temperature and frequency related impedance of a set of known substances.

At the measuring phase we are introducing a sample material between the plates of a second capacitor, we are exciting the first and second capacitors with a sequence of AC signals each at a different frequency over a frequency range and determining the voltage difference between the voltage across the first capacitor and the voltage across the second capacitor at each of the different frequencies. In this phase we are measuring the impedance change to a temperature sweep of an unknown substance in the same range of temperatures. Contrary to the calibration stage, at the measuring stage we vary the temperature by concrete steps, which must be at least three. In order to achieve the best match, the temperature steps must be eight or more.

At the comparison phase we are comparing the measured change to the stored values and determine the best match between the unknown substance and the stored values. The determination of the best match is done by using known algorithms, such as the ones used to identify specific forms, e.g. fingerprints.

BRIEF DESCRIPTION OF THE DRAWINGS

FIG. 1 is a block diagram of one version of a material identification system embodying features of the invention.

FIG. 2 is a block diagram of another version of a material identification system embodying features of the invention.

FIG. 3 is a block diagram of a third version of a material identification system embodying features of the invention.

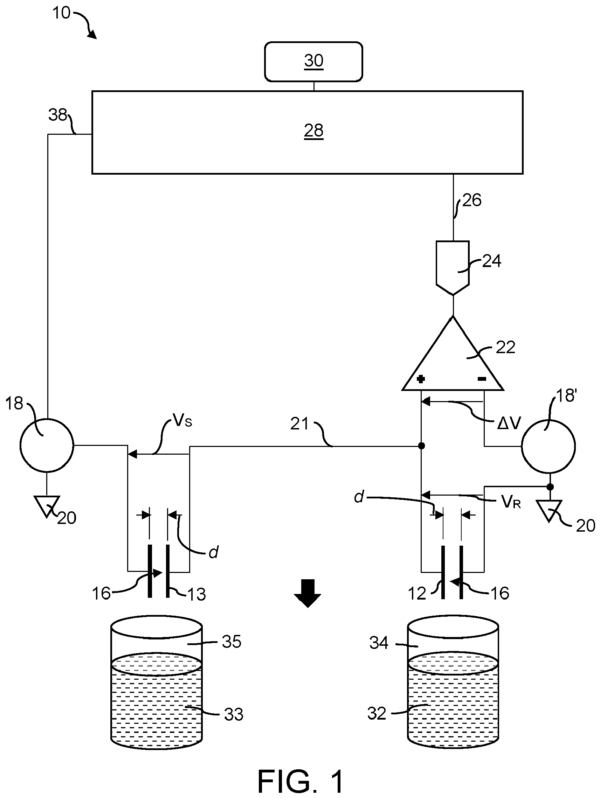

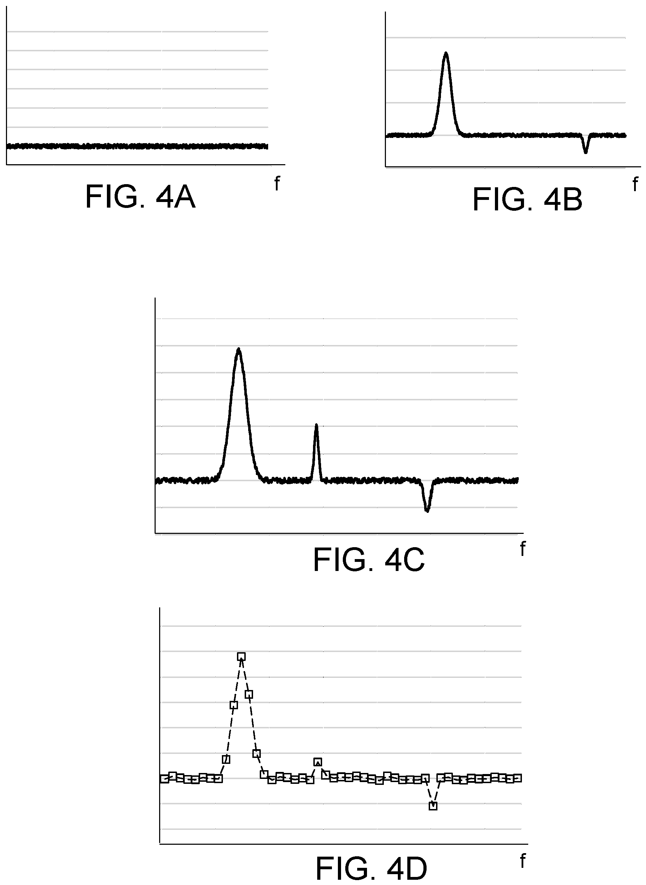

FIG. 4A is a continuous spectrum of the difference between the outputs of the sample and reference capacitors of a material identification system as in FIG. 1, 2, or 3 when the sample material is the same as the reference material; FIGS. 4B and 4C are continuous spectra of the difference between the outputs of the sample and reference capacitors for two sample-material examples that differ from the reference material; and FIG. 4D is a spectrum of the difference between the outputs of the sample and reference capacitors for the individual measurements made at various frequencies for the material with the spectrum of FIG. 4C.

FIG. 5 is the dielectric permittivity spectrum of the complex permittivity of a generic material up to about 10 GHz.

DETAILED DESCRIPTION

One version of a material identification system embodying features of the invention is shown in FIG. 1. The material identification system 10 includes a first parallel-plate capacitor 12 and a second parallel-plate capacitor 13. Both capacitors 12, 13 are identical in construction: they both have the same confronting plate area A and the same plate separation d across their inter-plate gaps 16. Although it complicates computations, the two capacitors 12, 13 do not have to be identical if their differences in construction are known. The two capacitors 12, 13 are connected in series with a signal generator 18, which applies an AC voltage to ground 20 across the series-connected capacitors. The resulting capacitive voltage divider produces an ac voltage $VR$, $VS$ across each capacitor 12, 13 with an output node 21 at their junction.

If the capacitances of the two capacitors balance, as they do when the capacitors' constructions are identical and the materials in the electric fields in the gaps 16 or in the capacitors' fringe electric fields outside the gaps are identical, $VS = VR$. If the materials have different dielectric permitivities $\varepsilon$, the impedances of the capacitors are unbalanced and $VS \neq VR$.

The connected plates of the two capacitors 12, 13 at the output node 21 are connected to the non-inverting input (+) of a differential amplifier 22. The inverting input (-) of the differential amplifier is connected to a slave signal generator channel 18', which outputs an ac voltage in phase with the ac voltage applied by the signal generator across the series-connected capacitors 12, 13. The amplitude of the ac voltage applied to the inverting input (-) is set to about half the amplitude of the ac voltage across the series-connected capacitors 12, 13. In that way the voltage at the inverting input (-) of the differential amplifier 22 is about equal to the voltage at the non-inverting input (+) when the materials in the gaps 16 are identical. Biasing the inverting input (-) of the differential amplifier 22 up to just below the level of the expected voltage $VR$ for a material match, allows the gain of the differential amplifier to be increased and makes the measurement more sensitive to changes in the capacitive impedances of the two capacitors 12, 13. But it is possible to operate the material identification system without the slave channel 18' and with the inverting input (-) of the differential amplifier 22 connected to ground 20. The output of the differential amplifier 22 is converted into a digital signal 26 by an analog-to-digital converter (ADC) 24.

The digital signal 26 is sent to a processor 28. The differential amplifier 22, the ADC 24, and the processor 28 form a voltage-comparison system that compares the voltages across the two capacitors 12, 13. The processor 28 may be realized as a general-purpose programmable computer or as an integrated circuit, such as a microprocessor, a microcontroller, a FPGA (field-programmable gate array), or as ASIC (application-specific integrated circuit), which may include an FPGA or a microprocessor or microcontroller and associated memory, or any hardware or software implementation capable of performing the required functions. The processor 28, when implemented with a programmable computer, microprocessor, microcontroller, or other software-programmable device, has program memory containing program instructions in a software program that are executed by the processor and volatile memory in which intermediate and final computations are stored. Also shown is a display 30 to which the processor 28 can send information to be monitored by an operator.

One way to operate the material identification system is shown in FIG. 1. A reference material 32, such as a liquid or a material carried in a liquid or a gas or a material in a gas, resides in a container 34. For example, to determine contaminants in water, distilled water could be used as the reference material. In the case of identifying an oil, some kind of oil could be used as the reference material. The reference material has known permittivity values at a plurality of frequencies over the RF (radio frequency) band 36 (FIG. 5) up to about 300 MHz, which includes the UHF (ultra-high frequency) band. Those permittivity values define the reference material's permittivity signature and determine the electrical impedance of the reference capacitor 12 at each frequency when all or part of the capacitor's plates are submerged in the reference liquid 34. A sample material 33 to be tested resides in a second container 35. Like the plates of the first capacitor 12, the plates of the second capacitor 13 are submerged the same depth in the sample liquid 33. (The material identification system 10 could be operated with the second capacitor 13 submerged in the reference material 32 and the first capacitor 12 submerged in the sample 33.) The signal generator 18 applies an ac voltage across the two capacitors 12, 13 at a first frequency tracked by the ac voltage applied by the slave channel 18'. The voltage, $\Delta V$ across the inputs to the differential amplifier 24 is measured. (Each voltage measurement consists of a series of measurement samples that are received in digital form by the processor 28.) The signal generator 18 then steps the frequency to a different second frequency and so on as the measurement process is repeated at several different frequencies.

The signal generator 18, under processor control via an energize control line 38, excites the capacitors 12, 13 with a sequence of different frequencies over a frequency range of, for example, about 30 kHz to about 300 MHz (the RF band) or even extended to frequencies as low as 10 Hz and frequencies as high as a few gigahertz for certain materials, for example 10 Ghz. And the voltage-comparison system measures the differential voltage $\Delta V$ at each of those frequencies. The steps between the measurement frequencies can be equal on a linear scale or on a logarithmic scale or can follow other patterns. The measurement duration can be equal at all frequencies or can be longer at the lower frequencies. So, too, the number of measurement samples can be equal at each frequency or can be greater at the lower frequencies. And the duration and number of samples can be increased for better accuracy in noisy conditions.

Because the permittivity of most materials is sensitive to temperature, another way to identify materials is to measure the differential voltage $\Delta V$ at one or more frequencies over a range of temperatures. The reference and sample materials 32, 33 are subjected to the same temperature in a temperature-controlled chamber, for example. The processor 28 controls the temperature along with the voltage measurements. So, instead of or in addition to a permittivity versus frequency signature from a frequency sweep, a permittivity versus temperature signature from a temperature sweep can be used to identify materials. Whether using a frequency sweep or a temperature sweep, the processor 28 uses a statistical process to determine whether the differential voltages $\Delta V$ exceed a predetermined threshold. If the threshold is exceeded, the processor 28 indicates that the sample material 33 does not match the reference material 32; otherwise, the processor indicates a match on the display 30, for example. The statistical process executed by the processor could, as one example, compute the sum of the squares of the differential voltages $\Delta V$ at each fre-

quency (or at each temperature) and compare that sum to the threshold.

If the sample and reference materials are identical, $\Delta V = 0$ over the frequency range as indicated by the continuous spectrum in FIG. 4A. If the sample material differs from the reference material, $\Delta V \neq 0$ across the frequency range as indicated by the example spectra in FIGS. 4B and 4C for two different materials. The continuous spectra of FIGS. 4B and 4C represent the signatures of the two example materials referred to a specific reference material. (The spectra depicted in FIGS. 4B and 4C do not represent the spectra produced by actual materials. They are artificial spectra used to help describe in simplified form the operation of the material identification system.) It's clear by comparing FIG. 4B to FIG. 4C that the two materials have different spectra. So a catalog of signatures of various materials in a selected reference material, such as distilled water, can be compiled beforehand, stored in the processor's memory, and used by the processor to help identify the sample material. And as shown in FIG. 4D, the measured spectrum of the material represented by the continuous spectrum of FIG. 4C is made up of a series of individual difference values at the discrete measurement frequencies as indicated by the squares in FIG. 4D.

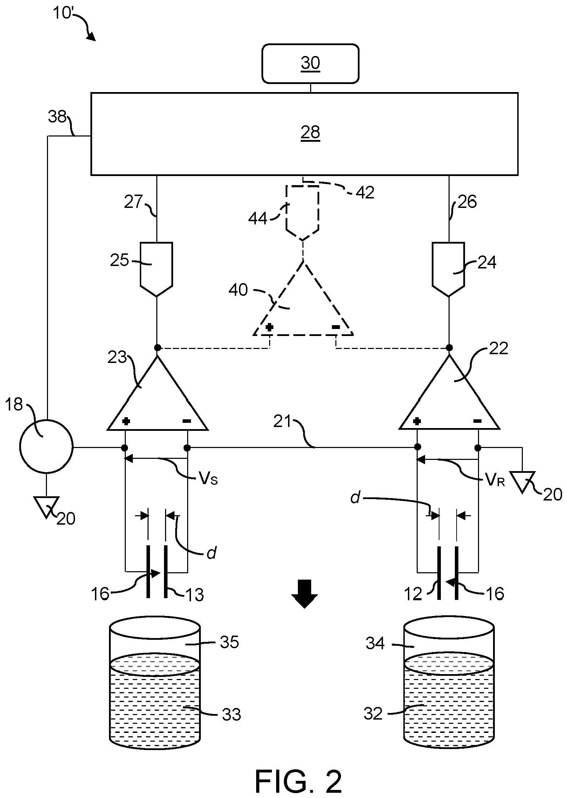

Another version of a material identification system 10' is shown in FIG. 2. The voltages $VR, VS$ across the capacitors 12, 13 are buffered in differential amplifiers 22, 23 and sent to analog-to-digital converters (ADCs) 24, 25. In this version the voltage $VR$ is the voltage at the output node 21. The ADCs 24, 25 convert the analog voltages $VR, VS$ into first and second digital signals 26, 27, which are received by the processor 28. Instead of separate ADCs 24, 25, a single ADC could be used with a multiplexer between the differential amplifiers 22, 23 and the single ADC. The differential amplifiers 22, 23, the ADCs 24, 25, and the processor 28 form the voltage-comparison system in this version.

Whether using a frequency sweep or a temperature sweep, the processor 28 computes the differences between the voltages ($VS - VR$), or ($VR - VS$), for each measurement set. Once all the differences are computed, the processor 28 uses a statistical process to determine whether the differences exceed a predetermined threshold. If the threshold is exceeded, the processor 28 indicates on the display 30, for example, that the sample material 33 does not match the reference material 32; otherwise, the processor indicates a match.

The voltage comparison can optionally be performed in hardware by a third differential amplifier 40 whose inputs are the outputs of the differential amplifiers 22, 23 measuring the voltages $VS, VR$ across the capacitors. The analog output of the third differential amplifier 40, which represents the difference ($VS- VR$) between the capacitors' voltages, is converted into a digital comparison signal 42 in a third ADC44 and sent to the processor 28. The processor 28 compares the comparison signal 42 to a threshold to determine whether the materials match.

The processor 28 can also compute the complex permittivity of the sample material from the voltage measurements. With *a priori* knowledge of the complex permittivity $\varepsilon$ of the reference material and by determining the phase shift between the voltage *VS* and the voltage *VR,* the processor 28 can compute the ratio of the real component $\varepsilon'$ to the imaginary component $\varepsilon''$ of the permittivity $\varepsilon$ of the sample material at each frequency (or temperature). And the magnitude of the permittivity can be determined from the difference between the magnitudes of the voltages *VS, VR.*

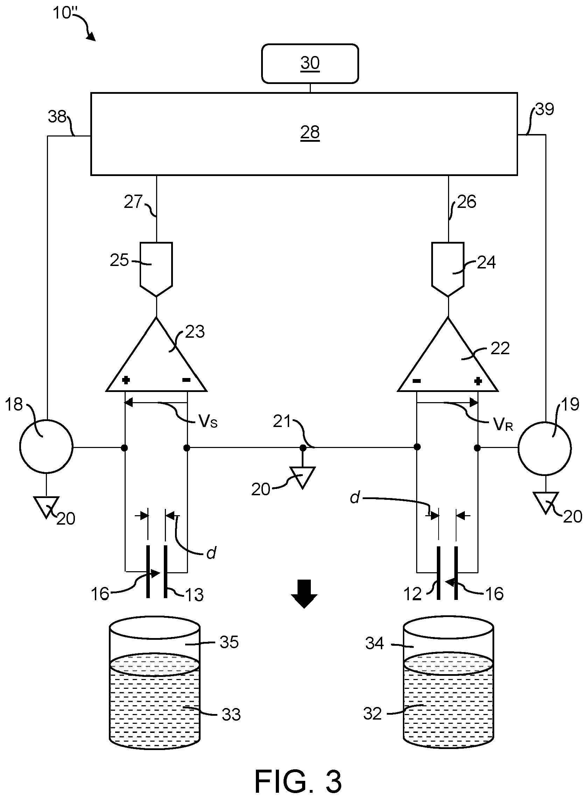

Yet another version of a material identification system 10" is shown in FIG. 3. In this version the inverting inputs (-) of the differential amplifiers 22, 23 are joined at an output node 21' connected to ground 20. The capacitors 12, 13 are connected across the inputs (+, -) of the differential amplifiers 22, 23. The capacitors 12, 13 are driven by signal generators 18, 19 connected to the non-inverting inputs (+) of the differential amplifiers 22, 23. The signal generators 18, 19 can be separate signal generators adjusted to output the same amplitude and frequency, or they can be buffered outputs of the same signal generator. The outputs of the two differential amplifiers 22, 23, representing the capacitor voltages, *VR, VS* are converted into corresponding digital signals 26, 27 in the ADCs 24, 25. The processor 28 receives the digital signals 26, 27, computes the differences (*VS - VR*) at each frequency, and compares them to a threshold to determine whether the materials match. As an alternative, the voltage difference (*VS - VR*) can be performed in hardware with a third differential amplifier 40 connected between the outputs of the differential amplifiers 22, 23 as in FIG. 2. The digital voltage difference 42 produced by the ADC 44 is sent to the processor 28 to be used to determine material matches.

Although features of the invention have been described in detail with respect to a few versions, other versions are possible. For example, the capacitors do not have to be submerged completely in a fluid. The plates could be positioned along the outer wall of the container with the material between them-if the effect of the wall on both capacitors is known. As another example, special-purpose reference capacitors preloaded beforehand with known reference materials could be used to avoid having to position the reference capacitor for each test of a new sample. As yet another example, solid materials could be positioned in the capacitors' electric fields. The plates do not have to be parallel plates. For example, the plates could be tubular, non-parallel, or some odd shape. So, as these few examples suggest, the claims are not meant to be limited to the details of the examples.

**Claims**

**1.** A method for identifying an unknown material comprising the steps of

   a) first measuring the temperature-related impedance change of a set of known substances in a first capacitor, whilst sweeping the temperature of the sample in a predetermined range,
   b) storing the results in a database
   c) introducing a sample material between the plates of a second capacitor
   d) exciting the first and second capacitors with a sequence of ac signals each at a different frequency over a frequency range
   e) determining the voltage difference between the voltage across the first capacitor and the voltage across the second capacitor at each of the different frequencies
   f) measuring the impedance change to a temperature sweep of an unknown substance in the same range of temperatures,
   g) comparing the measured change to the stored values and
   h) determining the best match between the unknown substance and the stored values.

**2.** A material identification method as claimed in claim 1 wherein the first and second capacitors are parallel-plate capacitors.

**3.** A material identification method as claimed in claim 1 wherein the frequency range extends across the RF band up to about 10 GHz.

**4.** A material identification method as claimed in claim 1 wherein the different frequencies are spaced apart by equal logarithmic frequency steps.

**5.** A material identification method as claimed in claim 1 wherein the voltage-comparison system measures both the difference in the magnitudes of the voltages across the first and second capacitors and the phase shift between the voltages across the first and second capacitors at each frequency.

**6.** The method of claim 1 comprising maintaining the reference material and the sample material at the same temperature.

**7.** The method of claim 1 further comprising measuring and comparing the voltage difference at at least one frequency at more than one temperature.

**8.** The method of claim 1 comprising determining the phase shift between the voltage across the first capacitor and the voltage across the second capacitor and using the phase shift to calculate the complex permittivity of the sample material.

**9.** The method of claim 1 wherein the reference material and the sample material are liquids or are carried in a liquid.

FIG. 1

FIG. 2

FIG. 3

FIG. 4A

f

FIG. 4B

f

FIG. 4C

f

FIG. 4D

f

FIG. 5

Europäisches
Patentamt
European
Patent Office
Office européen
des brevets

# EUROPEAN SEARCH REPORT

Application Number

EP 20 02 0034

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 898 309 A (BECKER ACHIM [DE] ET AL) 27 April 1999 (1999-04-27) * figures 1-6 * * column 2, line 61 - column 4, line 7 * ----- | 1-9 | INV. G01N27/02 G01R1/00 G01R27/00 |
| X | US 2011/246100 A1 (CARVALHO CARLOS E [US] ET AL) 6 October 2011 (2011-10-06) * figures 1-8 * * paragraph [0020] - paragraph [0090] * ----- | 1-9 | |
| A | US 6 437 551 B1 (KRULEVITCH PETER [US] ET AL) 20 August 2002 (2002-08-20) * figures 1, 2, 3, 6, 7 * * column 2, line 59 - column 15, line 52 * ----- | 2-6,8,9 | |
| A | US 5 691 633 A (LIU YING [GB] ET AL) 25 November 1997 (1997-11-25) * figures 1, 2, 6 * * column 6, line 11 - column 13, line 16 * ----- | 4,5,8,9 | |
| A | US 2006/192568 A1 (PASERO EROS [IT] ET AL) 31 August 2006 (2006-08-31) * paragraph [0015] * ----- | 7 | TECHNICAL FIELDS SEARCHED (IPC) G01N G01R |

The present search report has been drawn up for all claims

| Place of search | Date of completion of the search | Examiner |
|---|---|---|
| Munich | 18 May 2020 | Colasanti, Katharina |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 02 0034

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2020

| Patent document cited in search report | | Publication date | Patent family member(s) | | Publication date |
|---|---|---|---|---|---|
| US 5898309 | A | 27-04-1999 | DE 19536766 A1 | | 03-04-1997 |
| | | | EP 0767371 A1 | | 09-04-1997 |
| | | | JP H09138212 A | | 27-05-1997 |
| | | | US 5898309 A | | 27-04-1999 |
| US 2011246100 | A1 | 06-10-2011 | BR 112013026312 A2 | | 25-07-2017 |
| | | | CA 2833239 A1 | | 18-10-2012 |
| | | | CN 104115008 A | | 22-10-2014 |
| | | | EP 2699897 A1 | | 26-02-2014 |
| | | | RU 2013150585 A | | 20-05-2015 |
| | | | US 2011246100 A1 | | 06-10-2011 |
| | | | US 2014152322 A1 | | 05-06-2014 |
| | | | WO 2012142097 A1 | | 18-10-2012 |
| US 6437551 | B1 | 20-08-2002 | NONE | | |
| US 5691633 | A | 25-11-1997 | AT 172302 T | | 15-10-1998 |
| | | | DE 69321592 D1 | | 19-11-1998 |
| | | | DE 69321592 T2 | | 04-03-1999 |
| | | | EP 0651882 A1 | | 10-05-1995 |
| | | | JP H07509560 A | | 19-10-1995 |
| | | | KR 950702707 A | | 29-07-1995 |
| | | | US 5691633 A | | 25-11-1997 |
| | | | WO 9402846 A1 | | 03-02-1994 |
| US 2006192568 | A1 | 31-08-2006 | CA 2519817 A1 | | 17-03-2006 |
| | | | CN 1749743 A | | 22-03-2006 |
| | | | EP 1637875 A1 | | 22-03-2006 |
| | | | JP 2006162593 A | | 22-06-2006 |
| | | | KR 20060051435 A | | 19-05-2006 |
| | | | RU 2314519 C2 | | 10-01-2008 |
| | | | US 2006192568 A1 | | 31-08-2006 |

EPO FORM P0459

For more details about this annex : see Official Journal of the European Patent Office, No. 12/82